# EUROPÄISCHE PATENTSCHRIFT

(11) **EP 1 161 767 B1**
(45) Veröffentlichungstag und Bekanntmachung des Hinweises auf die Patenterteilung: **18.05.2011**
(21) Anmeldenummer: 00918684.2
(22) Anmeldetag: 03.03.2000
(51) Int. Cl.: H01L 21/336, H01L 21/331, H01L 21/265, H01L 21/225, H01L 29/78, H01L 29/739, H01L 29/10

(54) **Verfahren zur Herstellung einer vertikalen MOS-Transistoranordnung**
Method of making a vertical MOS transistor device
Méthode de fabrication d'un dispositif à transistor MOS vertical

(30) Priorität: 04.03.1999 DE 19909563
(43) Veröffentlichungstag der Anmeldung: 12.12.2001
(60) Teilanmeldung: 10009591.8
(73) Patentinhaber: Infineon Technologies AG, 85579 Neubiberg (DE)
(72) Erfinder: HIRLER, Franz, D-84424 Isen (DE); KANERT, Werner, D-83607 Holzkirchen (DE); GASSEL, Helmut, Farmington Hills, MI 48335 (US); STRACK, Helmut, D-80804 München (DE); PAIRITSCH, Herbert, A-9020 Klagenfurt (AT)
(74) Vertreter: Bickel, Michael
(86) Internationale Anmeldenummer: PCT/DE2000/000677
(87) Internationale Veröffentlichungsnummer: WO 2000/052750

(56) Entgegenhaltungen:
- EP-A- 1 009 036
- US-A- 4 837 606
- PATENT ABSTRACTS OF JAPAN vol. 013, no. 248 (E-770), 9. Juni 1989 (1989-06-09) -& JP 01 048464 A (HITACHI LTD), 22. Februar 1989 (1989-02-22)
- PATENT ABSTRACTS OF JAPAN vol. 1997, no. 12, 25. Dezember 1997 (1997-12-25) -& JP 09 213939 A (NEC CORP), 15. August 1997 (1997-08-15)
- PATENT ABSTRACTS OF JAPAN vol. 007, no. 036 (E-158), 15. Februar 1983 (1983-02-15) -& JP 57 188877 A (NIPPON DENKI KK), 19. November 1982 (1982-11-19)
- DEBOY G ET AL: "NEW GENERATION OF HIGH VOLTAGE MOSFETS BREAKS THE LIMIT LINE OF SILICON" INTERNATIONAL ELECTRON DEVICES MEETING, TECHNICAL DIGEST, SAN FRANCISCO, CA, USA, 6. - 9. Dezember 1998, Seiten 683-685, XP000859463 IEEE, NEW YORK, NY, USA ISBN: 0-7803-4775-7

## Beschreibung

Die vorliegende Erfindung betrifft ein Verfahren zur Herstellung eines Bodygebietes für eine vertikale MOS-Transistoranordnung in einem Halbleiterkörper, die einen verringerten spezifischen Einschaltwiderstand aufweist. Ein wesentlicher Faktor zur Optimierung des Einschaltwiderstandes von MOS-Transistoranordnungen ist die Verkürzung der Kanallänge der MOS-Struktur. Die minimal mögliche Kanallänge und damit der minimal mögliche Kanalwiderstand ist durch die sogenannte Punchfestigkeit festgelegt. Die Ladungsträgerkonzentration im Bodygebiet zwischen Sourcegebiet und Draingebiet muß so hoch sein, daß bis zur maximal erlaubten Drain-Source-Spannung sich die Raumladungszonen an den pn-Übergängen Sourcegebiet-Bodygebiet und Bodygebiet-Draingebiet nicht berühren, da sonst ein unzulässig hoher Strom fließt. Andererseits ist jedoch durch die bei üblichen MOS-Transistoranordnungen meist vorgegebene Einsatzspannung die maximale Ladungsträgerkonzentration des Bodygebietes im Kanalbereich festgelegt.

Die JP-A-01048464 beschreibt ein Verfahren zur Herstellung eines Leistungs-MOSFET, bei dem eine p-dotierte Bodyzone und eine in der Bodyzone angeordnete höher als die Bodyzone dotierte p-Zone durch aufeinanderfolgende Implantations- und Diffusionsschritte hergestellt werden.

Die JP-A-09213939 beschreibt einen vertikalen DMOS-Transistor, der eine Bodyzone und anschließend an die Bodyzone eine niedriger als die Bodyzone dotierte Halbleiterzone aufweist, die an die Driftzone angrenzt und die bei sperrendem Bauelement das sich in vertikaler Richtung ausbreitende elektrische Feld reduziert. Ein solches Bauelement ist außerdem beschrieben in Deboy et al., International Electron Devices Meeting, Technical Digest, San Francisco, CA, USA, 6.-9. Dezember 1998, Seiten 683-685.

Die JP-A-57188877 beschreibt einen vertikalen MOSFET und dessen Herstellungsverfahren. Bei diesem MOSFET werden zur Einstellung der Einsatzspannung Dotierstoffatome durch das Gateoxid in die fertig prozessierte Bodyzone implantiert.

Aufgabe der vorliegenden Erfindung ist es ein Verfahren zur Herstellung einer vertikalen MOS-Transistoranordnung bereitzustellen, wodurch eine Verringerung der Kanallänge der Transistoranordnung bei gleichbleibender Durchbruchsspannung und damit eine Verringerung des spezifischen Einschaltwiderstandes erreicht werden kann.

Diese Aufgabe wird gelöst durch die Merkmale des vorliegenden Anspruchs 1. Vorteilhafte Ausgestaltungen der Erfindung ergeben sich aus dem Unteransprüchen*.* Es wird ein Verfahren zur Herstellung einer vertikalen MOS-Transistoranordnung in einem Halbleiterkörper beschrieben, die ein Bodygebiet aufweist, das mindestens eine Kanalregion umfaßt, die zwischen einem Sourcegebiet zweiten Leitungstyps und einem Draingebiet zweiten Leitungstyps angeordnet ist und die an eine Gate-Elektrode angrenzt. Das Bodygebiet und das Sourcegebiet erstrecken sich dabei von einer ersten Oberfläche des Halbleiterkörpers aus in den Halbleiterkörper hinein, das Draingebiet erstreckt sich von einer zweiten Oberfläche des Halbleiterkörpers aus in den Halbleiterkörper hinein. Die Gate-Elektrode kann dabei beispielsweise entweder auf der ersten Oberfläche des Halbleiterkörpers angeordnet sein oder sie kann auch in einem Gate-Graben angeordnet sein, der sich in vertikaler Richtung von der ersten Oberfläche des Halbleiterkörpers aus in den Halbleiterkörper erstreckt.

Mindestens zwei Implantationen eines Dotiermaterials ersten Leitungstyps werden in den Halbleiterkörper durchgeführt. Die erste Implantation erfolgt derart, daß das Implantationsmaximum von der Kanalregion beabstandet angeordnet ist. Ist also die Gate-Elektrode der Transistoranordnung im Bereich der ersten Oberfläche angeordnet, und liegt somit auch die Kanalregion im Bereich der Oberfläche, so wird die erste Implantation derart durchgeführt, daß das Implantationsmaximum von der ersten Oberfläche zurückgesetzt im Halbleiterkörper liegt. Für den Fall einer Gate-Elektrode, die in einem vertikalen Gate-Graben angeordnet ist, wird die Implantation so durchgeführt, daß das Implantationsmaximum in lateraler Richtung vom Kanalgebiet zurückgesetzt angeordnet ist, welches sich entlang der Gate-Elektrode in vertikaler Richtung im Bodygebiet erstreckt. Es kann dabei auch gleichzeitig vorgesehen sein, daß das Implantationsmaximum ebenfalls von der ersten Oberfläche zurückgesetzt innerhalb des Halbleiterkörpers angeordnet ist.

Eine zweite Implantation von Dotiermaterial ersten Leitungstyps wird so durchgeführt, daß das Implantationsmaximum der zweiten Implantation im Halbleiterkörper ausgebend von der ersten Oberfläche unterhalb des Implantationsmaximums der ersten Implantation liegt, die Dosis der zweiten Implantation jedoch geringer ist als die Do-sis der ersten Implantation. Erfindungs gemäß erfolgt eine Ausdiffusion des durch die erste und die zweite Implentation eingebrachten Dotiermaterials erst, nach dem die erste und die zweite Implentationen durch gefürt werden

Die Vorgaben für die Implantation und Ausdiffusion des Dotiermaterials können dabei so eingestellt werden, daß im Gebiet der ersten Implantation des Dotiermaterials ein Gradient der Dotierungskonzentration in Richtung auf die Kanalregion hin erzielt werden kann. Damit kann erreicht werden, daß in der Kanalregion eine geringere Konzentration des Dotiermaterials und damit auch eine geringere Ladungsträgerkonzentration vorliegt, wodurch die Einsatzspannung der MOS-Transistoranordnung nicht wesentlich verändert wird. Andererseits wird jedoch durch die größere Konzentration des Dotier-materials, die von der Kanalregion beabstandet angeordnet wird, eine Erhöhung der Ladungsträgerkonzentration in einem Teilbereich des Bodygebietes erzielt werden, die die Punchfestigkeit der MOS-Transistoranordnung gewährleistet.

Die zweite Implantation mit geringerer Dotierungskonzentration unterhalb der ersten Implantation, also in einem Bereich des Bodygebietes, der dem Draingebiet zugewandt ist und in der Regel an eine Driftregion angrenzt, führt dazu, daß im Sperrfall der MOS-Transistoranordnung eine teilweise gegenseitige Ausräumung dieses Bereiches des Bodygebietes und der angrenzenden Driftregion des Draingebietes durch einen Kompensationseffekt erreicht werden kann. Somit kann bei der Anordnung eine Erhöhung der Durchbruchsspannung erzielt werden. Umgekehrt kann bei gleichbleibender Durchbruchsspannung die Dicke der Driftregion verringert und die Dotierung der Driftregion erhöht werden, was zu einer Verringerung des Einschaltwiderstandes führt.

Durch das erfindungsgemäße Verfahren kann somit auf einfache Weise ein optimiertes Dotierungsprofil eines Bodygebietes einer vertikalen MOS-Transistoranordnung erzeugt werden, die eine Verringerung des spezifischen Einschaltwiderstandes der MOS-Transistoranordnung erlaubt. Soweit dies wünschenswert ist, kann auch eine Erhöhung der Durchbruchsspannung erreicht werden. Aus dem Stand der Technik ist es prinzipiell beispielsweise aus der US -A-4, 809, 047 oder der US -A-4, 837, 606 bekannt, Implantationen von Dotiermaterial durchzuführen, um ein Dotierungsprofil im Bodygebiet zu erreichen. Diese Profile sind jedoch nicht dazu geeignet, in der erfindungsgemäßen Weise eine Verringerung des spezifischen Einschaltwiderstandes und eine Verbesserung der Spannungsfestigkeit der Transistoranordnung zu erreichen.

Die Dosis der ersten Implantation kann um einen Faktor im Bereich von 10 bis 1000 größer gewählt werden als die Dosis der zweiten Implantation. Speziell kann dabei die erste Implantation etwa um einen Faktor 100 größer gewählt werden als die Dosis der zweiten Implantation.

Sollte noch eine weitere Variation des Dotierungsprofils des Bodygebietes gewünscht sein, so können zusätzliche Verfahrensschritte vorgesehen werden, in denen Dotiermaterial in den Bereich des Bodygebietes eingebracht wird. So kann vorgesehen werden, daß z.B. nach einer Belegung der ersten Oberfläche mit Dotiermaterial ersten Leitungstyps in einem Diffusionsschritt das Dotiermaterial von der ersten Oberfläche aus in den Halbleiterkörper eindiffundiert wird. Damit kann beispielsweise erreicht werden, daß die Dotierungskonzentration im Bereich der Kanalregion noch genauer eingestellt werden kann, um die Einsatzspannung der Transistoranordnung noch genauer -auf einen gewünschten Wert einzustellen. Ein solcher Verfahrensschritt kann speziell dann Anwendung finden, wenn die Transistorstruktur eine grabenförmige Gate-Elektrode aufweist.

Es kann auch vorgesehen werden, daß in einem zusätzlichen dritten Implantationsschritt Dotiermaterial ersten Leitungstyps so in den Halbleiterkörper eingebracht wird, daß das Implantationsmaximum im Bereich der Kanalregion liegt. Durch einen solchen Schritt kann gezielt die Dotierungskonzentration in der Kanalregion und damit die Einsatzspannung der Transistoranordnung beeinflußt werden. Dieses Verfahren ist insbesondere dann relativ einfach durchführbar, wenn die Gate-Elektrode und damit die Kanalregion im Bereich der ersten Oberfläche des Halbleiterkörpers liegen. Das Verfahren kann jedoch auch prinzipiell dann Anwendung finden, wenn eine grabenförmige Gate-Elektrode vorgesehen ist. Hierbei muß jedoch gegebenenfalls die laterale Ausdehnung des Implantationsgebietes weitgehend eingeschränkt werden, um störende Einflüsse auf den übrigen Bereich der Transistorstruktur, speziell des Bodygebietes zu vermeiden.

Die Dosis der dritten Implantation kann im Bereich von 10 % bis 90 % der Dosis der ersten Implantation gewählt werden, speziell im Bereich von 50 % bis 60 % der Dosis der ersten Implantation.

Spezielle Beispiele des erfindungsgemäßen Verfahrens werden nachfolgend anhand der Figuren 1 bis 6 erläutert.

Es zeigen:
- Figur 1:: Zweifachimplantation zur Herstellung eines Bodyge- bietes einer vertikalen MOS-Transistoranordnung.
- Figur 2:: Schematische Darstellung einer vertikalen MOS- Transistoranordnung, bei der ein Herstellungsschritt nach Figur 1 Anwendung fand.
- Figur 3:: Verfahrensschritt gemäß Figur 1 mit einer zusätzli- chen, dritten Implantation in der Kanalregion.
- Figur 4:: Herstellungsschritt nach Figur 1 mit einer zusätzli- chen Eindiffusion von Dotiermaterial im Bodygebiet.
- Figur 5:: Herstellungsschritt nach Figur 4 bei einer vertika- len MOS-Transistoranordnung mit grabenförmigen Gate- Elektroden.
- Figur 6:: Schematische Darstellung einer fertigen vertikalen MOS-Transistoranordnung, die mit einem Herstellungs- schritt nach Figur 5 erzeugt wurde.

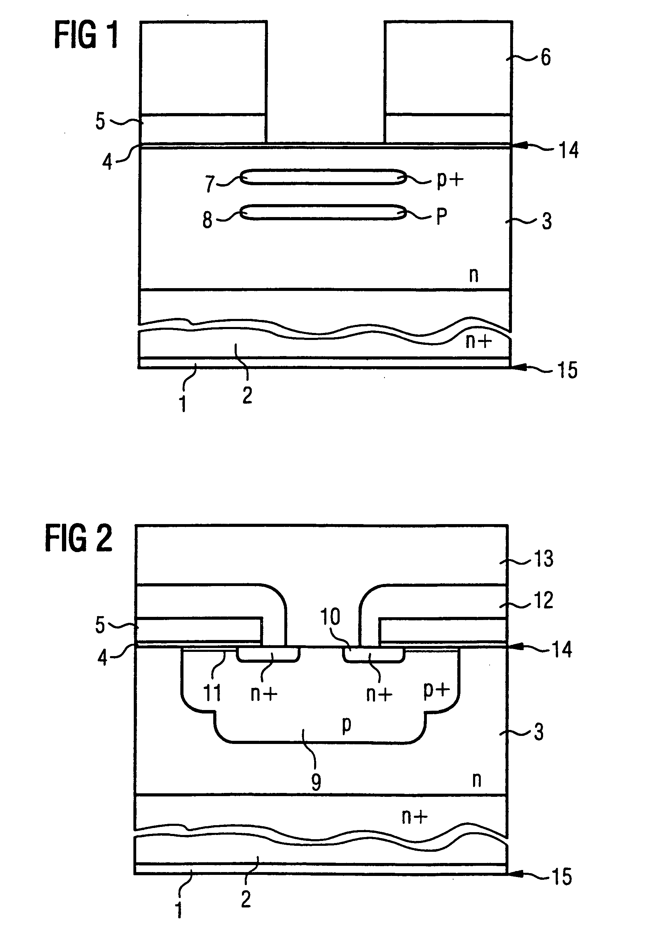

Figur 1 zeigt in einer schematischen Darstellung die Herstellung eines Bodygebietes einer vertikalen MOS-Transistoranordnung durch eine zweifache Implantation von Dotiermaterial ersten Leitungstyps, im vorliegenden Beispiel vom Typ P. Die MOS-Transistoranordnung besitzt eine erste Oberfläche 14 und eine zweite Oberfläche 15 weist eine n⁺-Drainzone 2 im Bereich der zweiten Oberfläche 15 auf. Auf diese zweite Oberfläche 15 ist eine Drain-Metallisierung 1 aufgebracht. Es kann jedoch auch vorgesehen sein, daß im Bereich dieser zweiten Oberfläche noch eine zusätzliche Anodenzone vorgesehen wird, auf die dann die entsprechende Metallisierung 1 aufgebracht wird. Solche Strukturen finden sich insbesondere bei IGBTs (Insulated Gate Bipolar Transistoren).

An die Drainzone 2 grenzt eine n-Driftzone 3 an. Diese erstreckt sich bis zu der ersten Oberfläche 14 der MOS-Transistoranordnung. Auf diese erste Oberfläche 14 ist eine Gateoxidschicht 4 aufgebracht. Auf dieser Gateoxidschicht 4 befinden sich Gate-Elektroden 5. Diese sind mit einem Fotolack 6 maskiert, der Öffnungen aufweist. Durch diese Öffnungen wird nun eine Implantation von Dotiermaterial vom Typ P vorgenommen. Es erfolgt dabei eine erste Implantation 7 mit einer höheren Dosis, die beispielsweise im Bereich von 5 x 10¹³ cm⁻² liegen kann. Wird als Dotiermaterial beispielsweise Bor verwendet, so erfolgt die Implantation mit einer Implantationsenergie von etwa 200 bis 400 keV, so daß das Implantationsmaximum in einer Tiefe von rund 500 nm liegt.

Es erfolgt weiterhin eine zweite p-Implantation 8, die jedoch nur mit einer Dosis von etwa 5 x 10¹¹ cm⁻² durchgeführt wird. Es ist hierfür für Bor eine Implantationsenergie von etwa 1 bis 2 MeV vorgesehen.

Eine Ausdiffusion dieser Implantation kann bei etwa 1100°C während einer Zeit von etwa 50 bis 100 Minuten erfolgen.

Figur 2 zeigt schematisch eine fertige MOS-Transistoranordnung, wobei das Bodygebiet 9 dieser Transistoranordnung nach einem Verfahrensschritt nach Figur 1 hergestellt werden kann. Es wird dabei deutlich, daß das Bodygebiet einen p⁺-Bereich höherer Dotierungskonzentration im Bereich unterhalb der ersten Oberfläche 14 aufweist, sowie einen p-Bereich niedrigerer Dotierungskonzentration, der sich in Richtung der Drainzone 2 erstreckt und an die Driftregion 3 angrenzt. Gerade in diesem unteren Bereich des Bodygebietes 9 kann eine gegenseitige Kompensation der p-Ladungsträger des Bodygebietes und der n-Ladungsträger der Driftregion erfolgen, so daß eine gegenseitige Ausräumung dieser Gebiete erfolgt und ein weitgehend intrinsisches Gebiet entsteht. Dieses Gebiet kann im Sperrfall einen großen Teil der Sperrspannung aufnehmen und trägt wesentlich zu einer verbesserten Spannungsfestigkeit der MOS-Transistoranordnung bei.

In Figur 2 sind weiterhin dargestellt:
Die Kanalregionen 11 im Bodygebiet 9, die zwischen den n⁺-Sourcegebieten 10 und der n-Driftzone 3 angeordnet sind. Über den Gate-Elektroden 5 ist eine weitere Oxidschicht 12 angeordnet. Durch eine Metallisierung 13 erfolgt eine Kontaktierung der n⁺-Sourcegebiete 10 und des p-Bodygebietes 9.

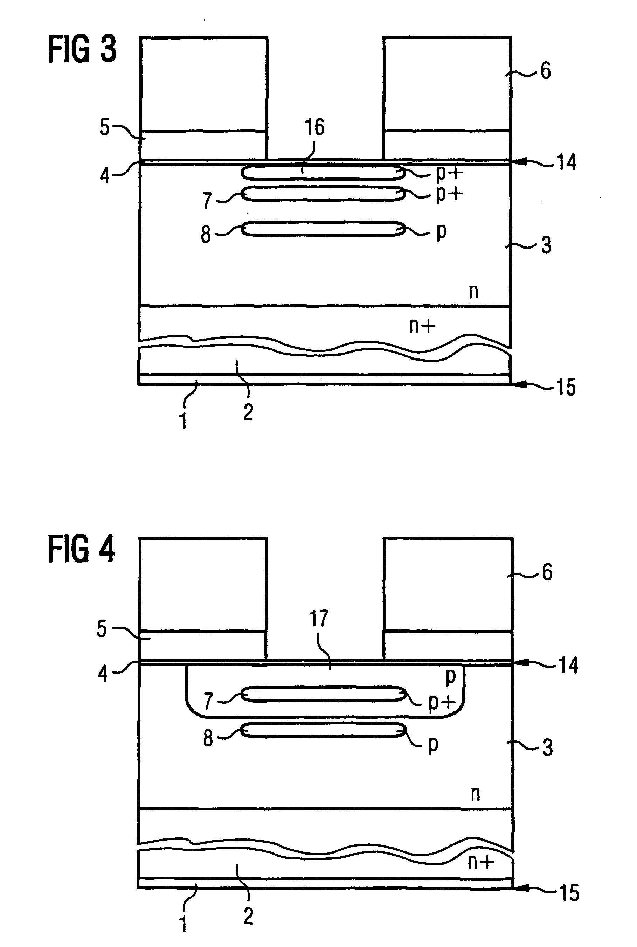

Figur 3 entspricht weitgehend dem in Figur 1 dargestellten Verfahrensschritt zur Herstellung des Bodygebietes 9. Hierbei ist jedoch im Bereich der späteren Kanalregion 11 der MOS-Transistoranordnung eine zusätzliche p⁺-Implantation 16 vorgesehen. Diese kann mit einer ähnlichen Dosis durchgeführt werden wie die erste Implantation 7. So wird beispielsweise eine Dosis von 3 x 10¹³ cm⁻² vorgesehen. Die Implantationsenergie beträgt für Bor etwa 50 keV. Das Maximum dieser zusätzlichen, dritten Implantation 16 liegt somit sehr nahe im Bereich der ersten Oberfläche 14. Diese dritte Implantation 16 wird dazu benutzt, die Dotierungskonzentration im Bereich der Kanalregion 11 der MOS-Transistoranordnung exakter einzustellen. Dies kann insbesondere dann vorgesehen werden, wenn als Dotiermaterial Bor verwendet wird. Durch eine Ausdiffusion der ersten Implantation 7 erfolgt nämlich keine Anreicherung von Bor an der Grenzfläche im Bereich der ersten Oberfläche 14. Bor zeigt vielmehr eher das gegenteilige Verhalten bezüglich seiner Segregation an Grenzflächen. Es kann somit bei Verwendung von Bor der Fall auftreten, daß durch diese Ausdiffusion eine etwas zu geringere Dotierungskonzentration im Bereich der Kanalregion erreicht wird oder diese Dotierungskonzentration nicht genau genug eingestellt werden kann. Zur genaueren Regulierung kann deshalb eine dritte Implantation hilfreich sein. Wird jedoch Phosphor als Implantationsmaterial verwendet, so kann bereits durch die erste Implantation 7 die Dotierungskonzentration im Kanalbereich 11 entsprechend eingestellt werden. Wird nämlich diese erste Implantation ausdiffundiert, so reichert sich der Phosphor im Bereich von Grenzflächen an, damit also auch im Bereich der ersten Oberfläche 14. Eine zusätzliche Implantation 16 kann damit entbehrlich sein, sie kann jedoch ebenfalls für eine exaktere Einstellung der Einsatzspannung als zusätzliche Maßnahme vorgesehen werden.

Unabhängig davon, ob nun eine dritte Implantation 16 vorgesehen wird oder nicht, wird jedoch erzielt , daß in einem Bereich des Bodygebietes 9, der von der Kanalregion 11 zurückgesetzt angeordnet ist, eine höhere Dotierungskonzentration erzielt wird als im Bereich der Kanalregion 11. Somit kann die Gesamtladung des Bodygebietes erhöht werden, wobei jedoch gleichzeitig die Einsatzspannung in der Kanalregion weitgehend unverändert gehalten werden kann.

Figur 4 zeigt eine Alternative zu Figur 3, wobei keine dritte Implantation 16 vorgesehen wird, sondern z.B. nach einer Belegung der Oberfläche mit Dotiermaterial ein Diffusionsschritt zur Erzeugung eines p-Diffusionsgebietes 17 im Bereich des späteren Bodygebietes 9. Damit kann bereits eine erste Hintergrunddotierung des Bodygebietes erzielt werden. Zusätzlich kann durch dieses Diffusionsgebiet 17 auch die Dotierungskonzentration in der Kanalregion 11 genauer eingestellt werden.

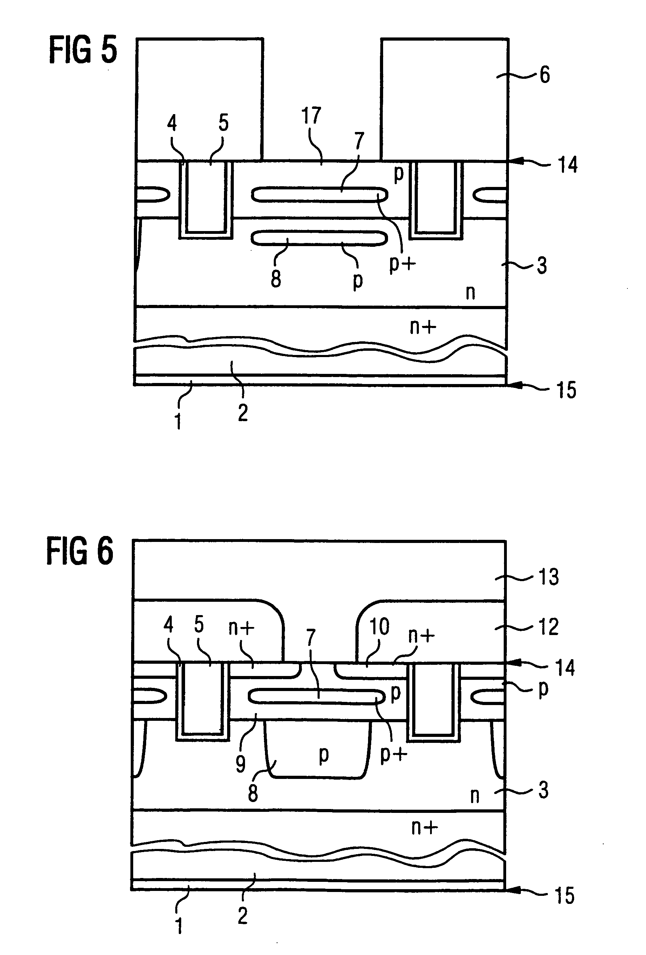

Figur 5 zeigt die Anwendung eines analogen Verfahrensschrittes zu Figur 4 bei einer MOS-Transistoranordnung, die grabenförmige Gate-Elektroden 5 aufweist. Dabei wurde bereits in einem Diffusionsschritt ein p-Diffusionsgebiet 17 zwischen den Gate-Elektroden 5 erzeugt. Anschließend erfolgt eine erste Implantation 7, deren Implantationsmaximum im Bereich des Diffusionsgebietes 17 liegt. Das Implantationsmaximum der zweiten Implantation 8 liegt unterhalb des Diffusionsgebietes 17. In einem oder mehreren weiteren Diffusionsschritten erfolgt die Ausdiffusion der ersten und zweiten Implantationen 7 und 8, so daß eine Struktur nach Figur 6 entsteht. Das fertige Bodygebiet 9 weist somit einen niedriger dotierten p-Bereich 8 auf, der sich in Richtung auf die Drainzone 2 hin erstreckt und an die Driftregion 3 angrenzt. In diesem Bereich kann durch eine Ladungsträgerkompensation mit der Driftregion 3 und somit eine gegenseitige Ausräumung dieser Gebiete eine erhöhte Spannungsaufnahme der MOS-Transistoranordnung erzielt werden. Umgekehrt kann bei gleicher Spannungsfestigkeit die Kanallänge verringert werden. Außerdem weist das Bodygebiet 9 einen weitgehend zentralen p⁺-Bereich 7 auf, der zu einer Erhöhung der Gesamtzahl der Ladungsträger im Bodygebiet und damit zu einer erhöhten Punchfestigkeit der MOS-Transistoranordnung beiträgt. Diese wirkt sich jedoch kaum auf die Kanalregion 11 aus, so daß die Einsatzspannung nicht wesentlich beeinflußt wird.

Bei allen Anordnungen kann durch das beschriebene Verfahren also bei gleichbleibender oder sogar erhöhter Spannungsfestigkeit und Punchfestigkeit der MOS-Kanal der Transistoranordnung verkürzt und der Einschaltwiderstand damit verringert werden.

## Patentansprüche

1. Verfahren zur Herstellung einer vertikalen MOS-Transistoranordnung in einem Halbleiterkörper, die
ein Bodygebiet (9) aufweist, das mindestens eine Kanalregion (11) umfaßt, die zwischen einem Sourcegebiet (10) zweiten Leitungstyps und einem Draingebiet (2, 3) zweiten Leitungstyps angeordnet ist und die an eine Gate-Elektrode (5) angrenzt,wobei sich das Bodygebiet (9) und das Sourcegebiet (10) von einer ersten Oberfläche (14) aus in den Halbleiterkörper erstrecken und wobei sich das Draingebiet (2, 3) von einer zweiten Oberfläche (15) aus in den Halbleiterkörper erstreckt,
wobei zur Herstellung des Bodygebiets (9) folgende Verfahrensschritte vorgesehen sind:
(a) eine erste Implantation eines Dotiermaterials eines ersten Leitungstyps über die erste Oberfläche (14) in den Halbleiterkörper, wobei das Implantationsmaximum der ersten Implantation innerhalb des Halbleiterkörpers von der Kanalregion (11) beabstandet ist,
(b) eine zweite Implantation eines Dotiermaterials des ersten Leitungstyps mit geringerer Dosis als die erste Implantation, wobei das Implantationsmaximum der zweiten Implantation innerhalb des Halbleiterkörpers ausgehend von der ersten Oberfläche (14) unterhalb des Implantationsmaximums der ersten Implantation liegt, wobei eine Ausdiffusion des durch die erste und die zweite Implantation eingebrachten Dotiermaterialsl erst erfolgt, nachdem die erste und die zweite Implantationen durchgeführt werden.

2. Verfahren nach Anspruch 1,
wobei die Dosis der ersten Implantation um einen Faktor 10 bis 1000 größer ist als die Dosis der zweiten Implantation.

3. Verfahren nach Anspruch 2,
wobei die Dosis der ersten Implantation um einen Faktor 100 größer ist als die Dosis der zweiten Implantation.

4. Verfahren nach einem der vorangehenden Ansprüche, wobei nach einer Belegung der ersten Oberfläche (14) mit Dotiermaterial des ersten Leitungstyps in einem zusätzlichen Diffusionsschritt das Dotiermaterial von der ersten Oberfläche (14) aus in den Halbleiterkörper eindiffundiert wird.

5. Verfahren nach einem der Ansprüche 1 bis 3,
wobei eine dritte Implantation von Dotiermaterial des ersten Leitungstyps durchgeführt wird, deren Implantationsmaximum im Bereich der Kanalregion (11) liegt.

6. Verfahren nach Anspruch 5,
wobei die Dosis der dritten Implantation 10 % bis 90 % der Dosis der ersten Implantation beträgt.

7. Verfahren nach Anspruch 6,
wobei die Dosis der dritten Implantation 50 % bis 60 % der Dosis der ersten Implantation beträgt.

## Claims

1. Method for fabricating a vertical MOS transistor arrangement in a semiconductor body, which arrangement has
a body region (9) comprising at least one channel region (11), which is arranged between a source region (10) of the second conduction type and a drain region (2, 3) of the second conduction type and which adjoins a gate electrode (5), the body region (9) and the source region (10) extending from a first surface (14) into the semiconductor body and the drain region (2, 3) extending from a second surface (15) into the semiconductor body,
the following method steps being provided in order to fabricate the body region (9):
(a) a first implantation of a doping material of a first conduction type via the first surface (14) into the semiconductor body, the implantation maximum of the first implantation within the semiconductor body being spaced apart from the channel region (11),
(b) a second implantation of a doping material of the first conduction type with a lower dose than the first implantation, the implantation maximum of the second implantation lying within the semiconductor body proceeding from the first surface (14) below the implantation maximum of the first implantation,
an outdiffusion of the doping material introduced by the first and the second implantation being carried out only after the first and second implantations have been carried out.

2. Method according to Claim 1,
the dose of the first implantation being a factor of 10 to 1000 greater than the dose of the second implantation.

3. Method according to Claim 2,
the dose of the first implantation being a factor of 100 greater than the dose of the second implantation.

4. Method according to one of the preceding claims, after doping material of the first conduction type has been deposited on the first surface (14), the doping material being diffused into the semiconductor body from the first surface (14) in an additional diffusion step.

5. Method according to one of Claims 1 to 3,
a third implantation of doping material of the first conduction type being carried out, the implantation maximum of said third implantation lying in the region of the channel region (11).

6. Method according to Claim 5,
the dose of the third implantation amounting to 10% to 90% of the dose of the first implantation.

7. Method according to Claim 6,
the dose of the third implantation amounting to 50% to 60% of the dose of the first implantation.

## Revendications

1. Procédé pour fabriquer un agencement de transistors MOS vertical dans un corps semiconducteur, qui comporte
une région (9) de corps, comportant au moins une région (11) de canal, qui est agencée entre une région (10) de source d'un second type de conductivité et une région (2, 3) de drain d'un second type de conductivité et qui est voisine d'une électrode (5) de grille, dans lequel la région (9) de corps et la région (10) de source s'étendent à partir d'une première surface (14) dans le corps semiconducteur et dans lequel la région (2, 3) de drain s'étend à partir d'une seconde surface (15) dans le corps semiconducteur,
dans lequel pour la fabrication de la région (9) de corps sont prévus les étapes de procédé suivantes:
(a) une première implantation d'un matériau dopant d'un premier type de conductivité par la première surface (14) dans le corps semiconducteur, le maximum d'implantation de la première implantation se trouvant à l'intérieur du corps semiconducteur à distance de la région (11) de canal,
(b) une deuxième implantation d'un matériau dopant du premier type de conductivité à une dose inférieure à celle de la première implantation, le maximum d'implantation de la deuxième implantation à l'intérieur du corps semiconducteur à partir de la première surface (14) étant en dessous du maximum d'implantation de la première implantation,
une diffusion du matériau dopant introduit par les première et deuxième implantations s'effectuant seulement après que les première et deuxième implantations ont été effectuées.

2. Procédé suivant la revendication 1, dans lequel la dose de la première implantation est plus grande que la dose de la seconde implantation d'un facteur de 10 à 1000 fois.

3. Procédé suivant la revendication 2, dans lequel la dose de la première implantation est plus grande que la dose de la deuxième implantation d'un facteur 100.

4. Procédé suivant l'une des revendications précédentes, dans lequel après que du matériau dopant du premier type de conductivité a été déposé sur la première surface (14), dans une étape de diffusion supplémentaire le matériau dopant est diffusé dans le corps semiconducteur à partir de la première surface (14).

5. Procédé suivant l'une des revendications 1 à 3, dans lequel il est effectué une troisième implantation de matériau dopant du premier type de conductivité, dont le maximum d'implantation se trouve dans la zone de la région (11) de canal.

6. Procédé suivant la revendication 5, dans lequel la dose de la troisième implantation représente entre 10 et 90% de la dose de la première implantation.

7. Procédé suivant la revendication 6, dans lequel la dose de la troisième implantation est comprise entre 50% et 60% de la dose de la première implantation.
